(19)

Europäisches
Patentamt
European
Patent Office
Office européen
des brevets

(11) **EP 2 549 224 B1**

(12) **EUROPEAN PATENT SPECIFICATION**

(45) Date of publication and mention
of the grant of the patent:
**04.05.2016  Bulletin 2016/18**

(51) Int Cl.:
***G01B 11/02*** *(2006.01)*  ***G02B 6/12*** *(2006.01)*

(21) Application number: **12177230.5**

(22) Date of filing: **20.07.2012**

(54) **Methods for improving integrated photonic device uniformity**

Verfahren zur Verbesserung der Gleichförmigkeit einer integrierten photonischen Vorrichtung

Procédés pour améliorer l'uniformité de dispositifs photoniques intégrés

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.07.2011  US 201161510047 P**

(43) Date of publication of application:
**23.01.2013  Bulletin 2013/04**

(73) Proprietors:
• **IMEC
3001 Leuven (BE)**
• **Universiteit Gent
9000 Gent (BE)**

(72) Inventors:
• **Absil, Philippe
3001 Leuven (BE)**
• **Selvaraja, Shankar Kumar
3001 Leuven (BE)**

(74) Representative: **Hertoghe, Kris Angèle Louisa et al
DenK iP bvba
Hundelgemsesteenweg 1114
9820 Merelbeke (BE)**

(56) References cited:
**WO-A2-02/14915      WO-A2-2007/143501
US-B2- 6 537 606**

## Description

### Field of the invention

The present invention relates to methods for improving the uniformity and repeatability of the spectral response of integrated photonic devices.

### Background of the invention

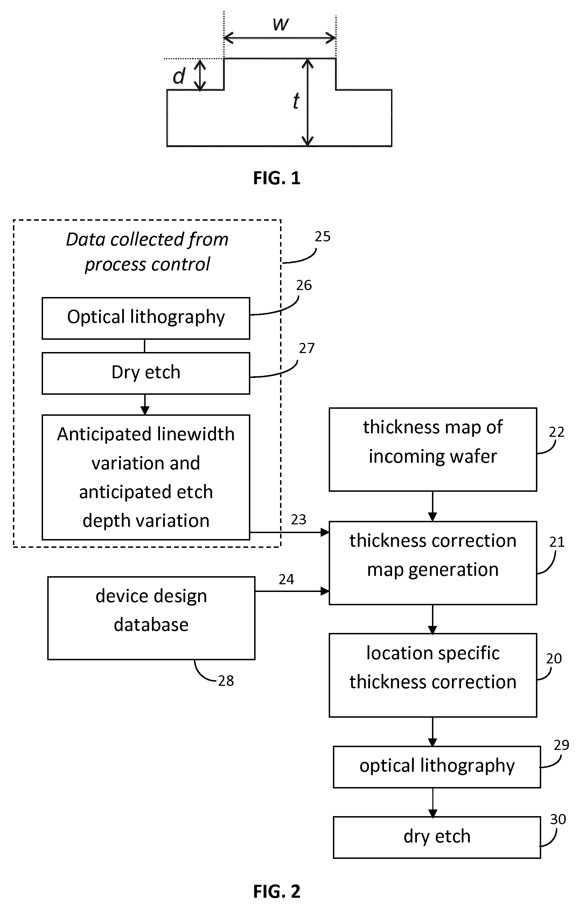

Integrated photonic devices fabricated in a high refractive index contrast material system, such as for example a Si/SiO$_2$ material system, are very sensitive to small variations in the device dimensions. Such devices are very sensitive to small variations in the thickness $t$ and etch depth d as well as to small variations in the linewidth w of the device structures made in the core material (e.g. Si) of the material system. Figure 1 shows a cross section of an exemplary photonic structure, illustrating thickness t, linewidth w and etch depth d. For example, a variation of 1 nm in the linewidth w can result in a shift in spectral response of wavelength selective photonic devices(such as e.g. ring resonators) in the order of 1 nm or 2 nm. Variations in the linewidth w and etch depth d of device structures are mainly influenced by the patterning process, including photolithography and etching. Variations in the thickness $t$ or height of the device structures are determined by the substrate manufacturing process.

For example, integrated photonic devices can be fabricated in thin semiconductor-on-insulator, e.g. silicon-on-insulator (SOI), substrates (comprising e.g. a 220 nm thick semiconductor, e.g. silicon, device layer on top of a 2000 nm thick insulator, e.g. silicon dioxide, layer). The thickness variation of the semiconductor, e.g. silicon, device layer of a semiconductor-on-insulator, e.g. silicon-on-insulator, substrate depends on the vendor specification. The thickness variation is typically 10% over the wafer or substrate. For a 220 nm thick semiconductor, e.g. silicon, device layer, this means a variation of about 22 nm in thickness of the semiconductor, e.g. silicon, device layer over the substrate. This may correspond to a shift or variation of about 22 nm to 44 nm in the spectral response of wavelength selective optical devices over the wafer. This is unacceptable for any commercial viable semiconductor, e.g. silicon, photonic technology.

In US 6,537,606 a method is described for improving the thickness uniformity and reducing the surface roughness of thin films such as the top silicon film of a silicon-on-insulator wafer. The method uses a vacuum GCIB (Gas Cluster Ion Beam) etching and smoothing process. After initial thickness non-uniformity characterization of the top silicon layer, the film thickness map information is fed into the GCIB beam-control apparatus as a data file. Based on a previously measured beam removal function and a previously measured relationship between etch rate and dose for a particular set of GCIB parameters, a mathematical algorithm is used to create a beam-dose contour to selectively remove surface material and thereby achieve a uniform film thickness.

WO 2007/143501 relates to non-linear optical waveguides that are single-moded over a wide range of wavelengths. Measured variations in the thickness of the core material layer can be compensated by variations of the width of the ridge to maintain constant phase velocity or group velocity matching in the disclosed waveguide device. Specifically, WO 2007/143501 discloses measuring the thickness across the core layer and fitting the results to a curve before designing the mask used to form the ridge.

### Summary of the invention

It is an object of embodiments of the present invention to provide methods for improving the uniformity of the spectral response of photonic devices over a wafer or substrate and for improving the repeatability of the spectral response of photonic devices from wafer to wafer and from batch to batch. The methods according to embodiments of the present invention can in particular advantageously be used for integrated photonic devices fabricated in a high refractive index contrast material system.

The above objective is accomplished by a method according to the present invention.

Particular and preferred aspects of the invention are set out in the accompanying independent and dependent claims. Features from the dependent claims may be combined with features of the independent claims as appropriate and not merely as explicitly set out in the claims.

The present invention provides a method for improving the uniformity and repeatability of the spectral response of photonic devices fabricated in a thin device layer such as a semiconductor, e.g. silicon, device layer of an SOI substrate, over a predetermined substrate area, wherein the method comprises: establishing an initial device layer thickness map for the predetermined area; establishing a linewidth map for the predetermined area and establishing an etch depth map for the predetermined area. Establishing the etch depth map comprises estimating the etch depth as a function of the spatial wafer coordinates in the predetermined area based on data previously collected from process control, or comprises measuring the etch depth as a function of the spatial wafer coordinates in the predetermined area after fabrication of the photonic devices.

The method further comprises based on the initial device layer thickness map, the linewidth map and the etch depth map, determining, e.g. calculating, a predetermined, e.g. an optimal, device layer thickness map and a corresponding thickness correction map for the predetermined substrate area taking into account device design data; and performing a location specific corrective etch process in accordance with the thickness correction map.

In a method according to embodiments of the present invention, establishing an initial device layer thickness map comprises measuring the initial thickness of the device layer over the predetermined substrate area as a function of x and y where x and y are the spatial wafer coordinates. For example, the initial device layer thickness can be measured by means of spectroscopic ellipsometry, e.g. with an accuracy better than 1 nm. The number of measurement points per wafer can for example be in the order of 300 to 400 points for a 200 mm wafer. However, the present invention is not limited thereto, and the number of measurement points per unit area can be higher or lower.

In a method according to embodiments of the present invention, establishing a linewidth map and establishing an etch depth map comprises measuring the linewidth and/or etch depth over the predetermined substrate area as a function of x and y where x and y are the spatial wafer coordinates. Measuring the linewidth and/or etch depth can for example be done by means of scatterometry.

In a method according to embodiments of the present invention, determining, e.g. calculating, a predetermined, e.g. an optimum, device layer thickness map comprises calculating as a function of the spatial wafer coordinates a predetermined, e.g. an optimum, device layer thickness needed for matching a predetermined spectral response of a photonic device. The thickness correction map may be determined by calculating the difference between the predetermined, e.g. optimum, device layer thickness and the initial device layer thickness as a function of the spatial wafer coordinates. This difference corresponds to the thickness correction to be performed by the location specific corrective etch process.

In embodiments of the present invention, the location specific corrective etch process can for example be a Gas Cluster Ion Beam process, as for example described in US 6,537,606.

The method of embodiments of the present invention is particularly relevant and advantageous for integrated photonic devices fabricated in a high refractive index contrast material system, i.e. a material system having a high refractive index contrast between a waveguide core material and a cladding material (difference in refractive index between the core material and the cladding material larger than 1). Photonic devices fabricated in such material systems are highly sensitive to process variations. Examples of such high refractive index contrast material systems are $Si/SiO_2$, $SiN/SiO_2$, $SiON/SiO_2$, $TaO_2/SiO_2$, $Si(O)C/SiO_2$, $InGaAsP/SiO_2$ and $Ge/Al_2O_3$.

In a first aspect of the present invention, the thickness correction map is established before starting the fabrication of photonic device structures and the location specific corrective etch process is performed before fabrication of the photonic device structures. Establishing the initial device layer thickness map may comprise measuring the initial thickness of the device layer on the non-processed substrate as a function of the spatial wafer coordinates in the predetermined area. Establishing a linewidth map and/or establishing an etch depth map may comprise estimating the linewidth and/or etch depth as a function of the spatial wafer coordinates in the predetermined area, based on data previously collected from process control.

In a second aspect of the present invention, the thickness correction map is established after fabricating the photonic device structures. Establishing the initial device layer thickness map may comprise measuring the thickness of the device layer on the processed substrate as a function of the spatial wafer coordinates in the predetermined area. Establishing a linewidth map and/or establishing an etch depth map may comprise measuring the linewidth and/or etch depth as a function of the spatial wafer coordinates in the predetermined area after fabrication of the photonic devices. In this second aspect, additionally the optical response of the photonic devices can be measured and this optical response (such as bandwidth, maximum wavelength, resonance wavelength, ...) of the devices can be used as an additional input for calculating the thickness correction map.

In embodiments of the present invention a thickness correction can be performed before fabricating the photonic device structures, according to the first aspect. In addition, after fabrication of the photonic device structures a supplementary thickness correction can be performed according to the second aspect.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example those skilled in the art will recognize that the invention may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the invention as claimed. The invention, both as to organization and method of operation, together with features and advantages thereof, may best be understood by reference to the following detailed description when read in conjunction with the accompanying drawings.

**Brief description of the drawings**

Figure 1 shows a cross section of an exemplary photonic structure, illustrating thickness t, linewidth w and etch depth d.
Figure 2 schematically illustrates a method according to embodiments of the present invention, wherein a thickness correction is performed before photonic device fabrication.
Figure 3 schematically illustrates a method according to embodiments of the present invention, wherein a thickness correction is performed after photonic device fabrication.
Figure 4 schematically illustrates methods according to embodiments of the present invention, wherein the semiconductor, e.g. silicon, device layer is thickened by epitaxial growth.

Any reference signs in the claims shall not be construed as limiting the scope of the present invention.
In the different drawings, the same reference signs refer to the same or analogous elements.

**Detailed description of illustrative embodiments**

In the following detailed description, numerous specific details are set forth in order to provide a thorough understanding of the invention and how it may be practiced in particular embodiments. However, it will be understood that the present invention may be practiced without these specific details. In other instances, well-known methods, procedures and techniques have not been described in detail, so as not to obscure the present disclosure. While the present invention will be described with respect to particular embodiments and with reference to certain drawings, the invention is not limited hereto. The drawings included and described herein are schematic and are not limiting the scope of the invention. It is also noted that in the drawings, the size of some elements may be exaggerated and, therefore, not drawn to scale for illustrative purposes.
Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.
Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.
It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.
The present invention provides methods for improving the uniformity, the repeatability and the controllability of the spectral response of integated photonic devices, using a location specific corrective etch process such as a GCIB (Gas Cluster Ion Beam) based thickness correction process. It is an advantage of methods according to embodiments of the present invention that they result in a better uniformity of the spectral response of photonic devices within a wafer, from wafer to wafer and from batch to batch, as compared to prior art methods.
The non-uniformity of the spectral response of integrated photonic devices depends on three physical factors thereof: linewidth, thickness or height and refractive index. Since the refractive index of the device layer, e.g. a semiconductor layer such as a silicon layer, is uniform over a wafer, linewidth and height variation are the dominant sources of non-uniformities. Since these two factors are interlinked, a variation in one factor can be compensated by a variation in the other factor. For example, a variation in height can be compensated by a variation in linewidth or vice-versa, a variation in linewidth can be compensated by a variation in height or thickness.
In a method according to embodiments of the present invention, the thickness of the devices may be corrected by using a location specific corrective etch process such as a Gas Cluster Ion Beam Process (GCIB), taking into account local linewidth and height data. A tailor-made thickness profile is used that compensates for the other systematic within-wafer process variations, e.g. related to photolithography processes (mask quality, resist thickness, projection optics, ..) or related to etch processes (such as plasma non-uniformities during dry etching).
In a first aspect, a pre-pattern thickness correction of the device layer (e.g. of a SOI substrate) is performed, i.e. a thickness correction is done before fabrication of the photonic devices. This is schematically illustrated in Figure 2. A location specific thickness correction 20 is performed based on a thickness correction map generated during a thickness correction map generation step 21. As opposed to prior art methods, wherein the thickness correction map is based only on the thickness map 22 of the incoming wafer, in a method according to embodiments of the present invention additional data 23, 24 are taken into account when generating 21 the thickness correction map. These additional data 23 comprise linewidth data and etch depth data or anticipated variations thereon, as previously collected 25 from optical lithography 26 and dry etch 27 process control, and device design data 24 stored in a device design database 28. Based on known process control data from optical lithography 26 and from dry etching 27, the local linewidth variation and the local etch depth variation are anticipated as a function of the spatial wafer coordinates, leading to an anticipated linewidth map and an anticipated etch depth map.

By combining the initial semiconductor e.g. silicon, thickness map 22, the anticipated linewidth map 23, the anticipated etch depth map 23 and design data 24, a thickness correction map is generated 21. This thickness correction map may be calculated based on the local device layer thickness needed for obtaining a predetermined spectral response of the photonic devices to be processed. A location specific thickness correction 20 is performed in accordance with the thickness correction map. As opposed to prior art methods, this location specific thickness correction 20 may not result in a device layer thickness that is as uniform as possible, but it results in a device layer thickness that is tuned for obtaining best device performance.

After the location specific thickness correction 20, the photonic devices are processed, for instance in a conventional way, such as using e.g. optical lithography steps 29 and dry etching steps 30. This leads to devices with uniform spectral response over the wafer.

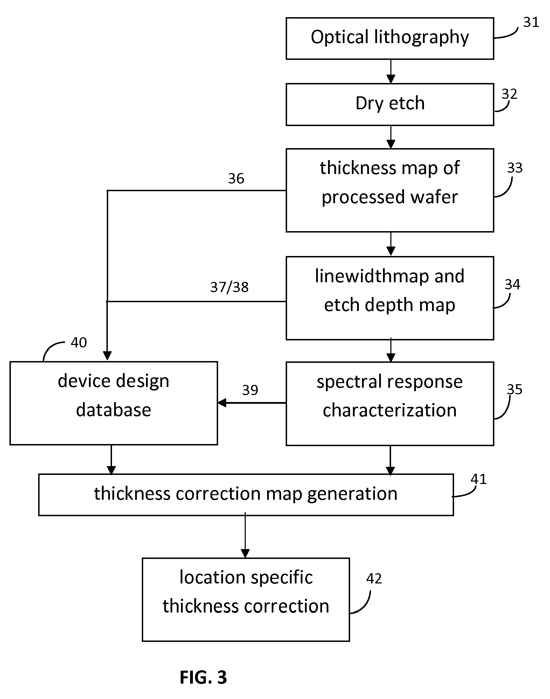

In a second aspect, a post-pattern thickness correction of the device layer (e.g. of a SOI substrate) is performed, i.e. a thickness correction is done only after fabrication of the photonic devices. This is schematically illustrated in Figure 3. After fabrication of the photonic devices using optical lithography 31 and etching steps such as dry etching 32, a characterization of the local linewidth, etch depth and thickness of the fabricated structures is performed as a function of the spatial wafer coordinates. Hereto, a thickness map 33 of the processed wafer may be determined, and from this thickness map, a linewidth map and an etch depth map 34 may be determined. In additon to the characterisation of linewidth, etch depth and thickness, the spectral response of the photonic devices can be measured 35. Based on a combination of local thickness 36, local linewidth 37, local etch depth 38, optical response 39 and device design data retrieved from a device design database 40, a thickness correction map 41 is generated. In accordance with embodiments of the present invention, this thickness correction map 41 is then used to perform a location specific thickness correction 42.

When using GCIB for corrective etching, the ion beam damages a surface portion of the semiconductor, e.g. silicon, layer, extending about 10 nm to 20 nm from the semiconductor, e.g. silicon, surface. The nature of this damage is twofold, firstly structural damage and secondly chemical damage. In the photonic devices, these damages may lead to absorption and scattering of propagating light, resulting in undesirable propagation losses. In order to cure these defects, a thermal annealing step can be performed. The thermal annealing step may preferably be done at a temperature above 600ºC, e.g. at a temperature in the range between 800ºC and 1000ºC, during 10 to 30 minutes. For higher annealing temperatures shorter annealing times can be used. It was shown that such thermal annealing step can reduce propagation losses by a factor of 10 and or more.

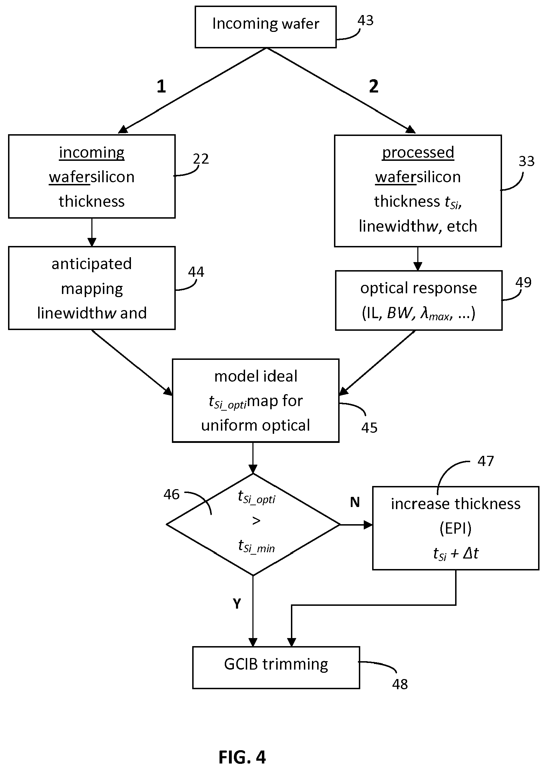

In embodiments of the present invention, the initial thickness of the device layer, e.g. semiconductor layer such as silicon layer, as determined when generating the thickness map 22, 33 of the wafer, can be increased by epitaxial growth before performing the location specific thickness correction 20, 42 according to embodiments of the present invention, for example when the minimum initial thickness of the device layer is smaller than a predetermined, optionally optimum, thickness of the device layer. This is schematically illustrated in Figure 4, wherein the device layer is assumed to be a silicon layer, e.g. a top layer of a silicon-on-insulator substrate.

Figure 4 schematically shows a diagram illustrating a method embodiment of the present invention. In a first aspect ((1) in Figure 4), an initial silicon thickness map 22, 33 of an incoming wafer 43 is first established. The device layer thickness, e.g. silicon layer thickness $t_{Si}$, can be described as a distribution $\delta(x, y, T)$ where x and y are the spatial wafer coordinates and where $T$ is the time. The initial thickness map corresponds to $T = T_0$. Taking into account an anticipated map 44 of linewidth w and etch depth d, and taking into account design data, a predetermined, e.g. an optimum, silicon thickness $t_{Si\_opti}$ for obtaining a predetermined spectral response may be determined 45 as a function of the spatial wafer coordinates x and y. If, as checked in step 46, the predetermined, e.g. optimum, silicon thickness $t_{Si\_opt}$ for the photonic devices to be fabricated is smaller than the minimum initial thickness $t_{Si\_min}$ of the silicon layer, the silicon thickness can be increased 47, for example by growth of an epitaxial silicon layer with thickness $\Delta t$, and the location specific thickness correction 48 (e.g. by means of GCIB) according to embodiments of the present invention can be performed on the thickened wafer. If, as checked in step 46, the predetermined, e.g. optimum silicon thickness $t_{Si\_opti}$ is larger than the minimum initial thickness $t_{Si\_min}$ over the entire wafer, the thickness correction 48 according to embodiments of the present invention can be performed directly on the incoming wafer, without thickening by epitaxial growth.

In a second aspect ((2) in Figure 4), the wafer is processed first and a map 33 of silicon thickness $t_{Si}$, linewidth w and etch depth d is established on the processed incoming wafer 43 as a function of the spatial wafer coordinates *x* and *y*. The optical response of the photonic devices is then determined 49 (e.g. insertion loss *IL*, bandwidth *BW*, $\lambda_{max}$, ...), and a map of a predetermined, e.g. optimum, silicon thickness $t_{Si\_opti}$ is determined 45 for optimized optical response. The difference between the initial silicon layer thickness $t_{Si}$ and the predetermined, e.g. optimum, silicon layer thickness $t_{Si\_opti}$ corresponds to the amount of silicon that needs to be etched locally during the corrective etch process 48. If, as checked in step 46, the predetermined, e.g. optimum, silicon thickness $t_{Si\_opt}$ is smaller than the minimum initial thickness $t_{Si\_min}$ of the silicon layer, the silicon thickness can be increased by growth of an epitaxial silicon layer with thickness $\Delta t$, and the location specific thickness correction 48 (e.g. by means of GCIB) according to embodiments of the present invention can be performed on the thickened wafer. If, as checked in step 46, the predetermined, e.g. optimum, silicon thickness $t_{Si\_opti}$ is larger than the minimum initial thickness $t_{Si\_min}$ over the entire wafer, the method according to the present invention can be performed directly on the incoming wafer, without thickening by epitaxial growth.

Simulations were performed to illustrate the use of a method according to embodiments of the present invention for the case of fiber couplers fabricated in a silicon device layer of an SOI wafer. A key parameter for fiber grating couplers is the wavelength $\lambda_{max}$ at which maximum coupling is achieved between a fiber and an integrated waveguide on the substrate. Analysis of the modelling of fiber grating couplers shows that a good approximation of this wavelength of maximum coupling is given by a linear fit:

$$\lambda_{max} = \lambda_0 + a * t_{Si} + b * w + c * d$$

wherein a, b and c are fitting parameters.

For a given selection of $\lambda_{max}$ it can be derived that:

$$t_{Si}(x, y, T) = \frac{(\lambda_{max} - \lambda_0 - c * d(x, y, T) - b * w(x, y, T))}{a}$$

Assuming that T - $T_0$ is much smaller than the process stability time scale, this can be written as:

$$t_{Si}(x, y, T) = \frac{(\lambda_{max} - \lambda_0 - c * d(x, y, T_0) - b * w(x, y, T_0))}{a}$$

For a fixed choice of coupling angle (13 degrees), cladding layer thickness (1 micrometer) and grating period (340 nm), a fit over more than 5000 simulation data points results in:

$$\lambda_{max} \cong 1300.9 + 1931.8 * t_{Si} - 205.2 * w - 1151.1 * d$$

wherein $\lambda_{max}$, $t_{Si}$, wand dare expressed in nm.

Based on in-line measurement data it was found that the average value of $\lambda_{max}$ is 1567 nm with a standard deviation of 3.9 nm wafer-to-wafer within a lot. Based on long term lot-to-lot repeatability measurements, it was found that the average $\lambda_{max}$ can vary from 1552 nm up to 1578 nm, which is a difference of up to 26 nm.

Assuming a GCIB control standard deviation of $\pm$ 1 nm, the wafer-to-wafer non-uniformity equals the lot-to-lot non-uniformity for $\lambda_{max}$ = $\lambda_{target}\pm$ 2 nm (2 nm standard deviation) with a range of about 10 nm, to be compared to the 26 nm without GCIB correction.

## Claims

1.    A method for improving, over a predetermined substrate area, the uniformity and repeatability of the spectral response of photonic devices fabricated in a thin device layer of an SOI substrate, the method comprising:

  establishing an initial device layer thickness map for the predetermined area;
  establishing a linewidth map for the predetermined area; and
  establishing an etch depth map for the predetermined area, in which establishing the etch depth map comprises estimating the etch depth as a function of the spatial wafer coordinates in the predetermined area based on data previously collected from process control,

**characterised in that** the method further comprises, based on the initial device layer thickness map, the linewidth map and the etch depth map,

determining a predetermined device layer thickness map and a corresponding thickness correction map for the predetermined substrate area taking into account device design data;

performing a location specific corrective etch process in accordance with the thickness correction map, and fabricating photonic device structures, wherein the thickness correction map is established before starting said fabrication of photonic device structures and the location specific corrective etch process is performed before said fabrication of the photonic device structures.

2. A method according to claim 1, wherein establishing an initial device layer thickness map comprises measuring the initial thickness of the device layer over the predetermined substrate area as a function of x and y where x and y are the spatial wafer coordinates.

3. A method according to claim 1, wherein measuring the initial device layer thickness includes performing spectroscopic ellipsometry.

4. A method according to any of the previous claims, wherein determining a predetermined device layer thickness map comprises calculating as a function of spatial wafer coordinates a particular device layer thickness needed for matching a predetermined spectral response of a photonic device.

5. A method according to any of the previous claims, wherein determining a thickness correction includes calculating a difference between the predetermined device layer thickness and the initial device layer thickness as a function of spatial wafer coordinates.

6. A method according to any of the previous claims, wherein the location specific corrective etch process is a Gas Cluster Ion Beam process.

7. A method according to any of the previous claims, wherein establishing the initial device layer thickness map comprises measuring the initial thickness of the device layer on a non-processed substrate as a function of spatial wafer coordinates in the predetermined area.

8. A method according to any of the previous claims, wherein establishing a linewidth map comprises estimating the linewidth as a function of spatial wafer coordinates in the predetermined area, based on data previously collected from process control.

**Patentansprüche**

1. Verfahren zur Verbesserung, über einen vorausbestimmten Substratbereich, der Gleichförmigkeit und Wiederholbarkeit der spektralen Empfindlichkeit von photonischen Vorrichtungen, die in einer dünnen Vorrichtungsschicht eines SOI-Substrats hergestellt werden, wobei das Verfahren Folgendes umfasst:

Erstellen eines Plans für die anfängliche Vorrichtungsschichtstärke für den vorausbestimmten Bereich;

Erstellen eines Plans für die Linienbreite für den vorausbestimmten Bereich; und

Erstellen eines Plans für die Ätztiefe für den vorausbestimmten Bereich, wobei das Erstellen des Plans für die Ätztiefe das Schätzen der Ätztiefe in Abhängigkeit von den Wafer-Raumkoordinaten im vorausbestimmten Bereich basierend auf Daten umfasst, die zuvor aus der Prozesskontrolle erfasst werden,

**dadurch gekennzeichnet, dass** das Verfahren, basierend auf dem Plan für die anfängliche Vorrichtungsschichtstärke, dem Plan für die Linienbreite und dem Plan für die Ätztiefe, ferner

das Bestimmen eines Plans für die vorausbestimmte Vorrichtungsschichtstärke und eines Plans für die entsprechende Stärkenkorrektur für den vorausbestimmten Substratbereich unter Berücksichtigung von Vorrichtungsausführungsdaten;

das Durchführen eines ortsspezifischen korrektiven Ätzprozesses in Übereinstimmung mit dem Plan für die Stärkenkorrektur, und

das Herstellen photonischer Vorrichtungsstrukturen umfasst, wobei der Plan für die Stärkenkorrektur vor Beginn der Herstellung von photonischen Vorrichtungsstrukturen erstellt wird und der ortsspezifische korrektive Ätzprozess vor der Herstellung der photonischen Vorrichtungsstrukturen durchgeführt wird.

**2.** Verfahren nach Anspruch 1, wobei das Erstellen eines Plans für die anfängliche Vorrichtungsschichtstärke das Messen der anfänglichen Stärke der Vorrichtungsschicht über den vorausbestimmten Substratbereich in Abhängigkeit von x und y umfasst, wobei x und y die Wafer-Raumkoordinaten sind.

**3.** Verfahren nach Anspruch 1, wobei das Messen der anfänglichen Vorrichtungsschichtstärke das Durchführen einer spektroskopischen Ellipsometrie umfasst.

**4.** Verfahren nach einem der vorhergehenden Ansprüche, wobei das Bestimmen eines Plans für die vorausbestimmte Vorrichtungsschichtstärke das Berechnen, in Abhängigkeit von Wafer-Raumkoordinaten, einer speziellen Vorrichtungsschichtstärke umfasst, die zum Zuordnen einer vorausbestimmten spektralen Empfindlichkeit einer photonischen Vorrichtung nötig ist.

**5.** Verfahren nach einem der vorhergehenden Ansprüche, wobei das Bestimmen einer Stärkenkorrektur das Berechnen einer Differenz zwischen der vorausbestimmten Vorrichtungsschichtstärke und der anfänglichen Vorrichtungsschichtstärke in Abhängigkeit von Wafer-Raumkoordinaten umfasst.

**6.** Verfahren nach einem der vorhergehenden Ansprüche, wobei der ortsspezifische korrektive Ätzprozess ein Gas-Clusterionenstrahl-Prozess ist.

**7.** Verfahren nach einem der vorhergehenden Ansprüche, wobei das Erstellen des Plans für die anfängliche Vorrichtungsschichtstärke das Messen der anfänglichen Stärke der Vorrichtungsschicht auf einem unbearbeiteten Substrat in Abhängigkeit von Wafer-Raumkoordinaten im vorausbestimmten Bereich umfasst.

**8.** Verfahren nach einem der vorhergehenden Ansprüche, wobei das Erstellen eines Plans für die Linienbreite das Schätzen der Linienbreite in Abhängigkeit von Wafer-Raumkoordinaten im vorausbestimmten Bereich basierend auf Daten umfasst, die zuvor aus der Prozesskontrolle erfasst werden.

## Revendications

**1.** Procédé permettant d'améliorer, sur une zone de substrat prédéterminée, l'uniformité et la répétabilité de la réponse spectrale de dispositifs photoniques fabriqués dans une couche de dispositif mince d'un substrat de SOI, le procédé comprenant :

l'établissement d'une carte d'épaisseur de couche de dispositif initiale pour la zone prédéterminée ;
l'établissement d'une carte de largeur de raie pour la zone prédéterminée ; et
l'établissement d'une carte de creux de gravure pour la zone prédéterminée, l'établissement d'une carte de creux de gravure comprenant l'estimation du creux de gravure en fonction des coordonnées de tranche spatiales dans la zone prédéterminée d'après des données collectées plus tôt à partir de la commande de traitement,
**caractérisé en ce que** le procédé comprend en outre, d'après la carte d'épaisseur de couche de dispositif initiale, la carte de largeur de raie et la carte de creux de gravure,
la détermination d'une carte d'épaisseur de couche de dispositif prédéterminée et d'une carte de correction d'épaisseur correspondante pour la zone de substrat prédéterminée en prenant en considération des données de conception de dispositif ;
la réalisation d'un traitement de gravure corrective spécifique à l'emplacement selon la carte de correction d'épaisseur, et
la fabrication de structures de dispositif photonique, la carte de correction d'épaisseur étant établie avant le démarrage de ladite fabrication de structures de dispositif photonique et le traitement de gravure corrective spécifique à l'emplacement étant réalisé avant ladite fabrication des structures de dispositif photonique.

**2.** Procédé selon la revendication 1, dans lequel l'établissement d'une carte d'épaisseur de couche de dispositif initiale comprend la mesure de l'épaisseur initiale de la couche de dispositif sur la zone de substrat prédéterminée en fonction de x et de y, où x et y sont les coordonnées de tranche spatiales.

**3.** Procédé selon la revendication 1, dans lequel la mesure de l'épaisseur de couche de dispositif initiale inclut la réalisation d'une ellipsométrie spectroscopique.

**4.** Procédé selon l'une quelconque des revendications précédentes, dans lequel la détermination d'une carte d'épaisseur de couche de dispositif prédéterminée comprend le calcul en fonction de coordonnées de tranche spatiales d'une épaisseur de couche de dispositif particulière nécessaire pour concorder avec une réponse spectrale prédéterminée d'un dispositif photonique.

5. Procédé selon l'une quelconque des revendications précédentes, dans lequel la détermination d'une correction d'épaisseur comprend le calcul d'une différence entre l'épaisseur de couche de dispositif prédéterminée et l'épaisseur de couche de dispositif initiale en fonction des coordonnées de tranche spatiales.

6. Procédé selon l'une quelconque des revendications précédentes, dans lequel le traitement de gravure corrective spécifique à l'emplacement est un traitement de faisceaux ioniques d'agrégats de gaz.

7. Procédé selon l'une quelconque des revendications précédentes, dans lequel l'établissement d'une carte d'épaisseur de couche de dispositif initiale comprend la mesure de l'épaisseur initiale de la couche de dispositif sur un substrat non traité en fonction de coordonnées de tranche spatiales dans la zone prédéterminée.

8. Procédé selon l'une quelconque des revendications précédentes, dans lequel l'établissement d'une carte de largeur de raie comprend l'estimation de la largeur de raie en fonction de coordonnées de tranche spatiales dans la zone prédéterminée, d'après des données collectées plus tôt à partir de la commande de traitement.

**FIG. 1**

**FIG. 2**

```
                                   ┌─────────────────────┐  ╭ 31
                                   │  Optical lithography │ ╱
                                   └──────────┬──────────┘
                                              │
                                              ▼
                                   ┌─────────────────────┐  ╮ 32
                                   │      Dry etch        │ ╱
                                   └──────────┬──────────┘
                                              │
                                              ▼
              36          ┌────────────────────────────────┐  ╮ 33
        ┌─────────────────┤      thickness map of          │ ╱
        │                 │      processed wafer           │
        │                 └───────────────┬────────────────┘
        │                                 │
        │                                 ▼
        │      37/38      ┌────────────────────────────────┐  ╮ 34
        │     ┌───────────┤      linewidthmap and          │ ╱
        │     │           │      etch depth map            │
        │     │           └───────────────┬────────────────┘
   40   │     │                           │
    ╭───┤     ▼                           ▼
   ┌────┴─────────────┐   39   ┌────────────────────────────┐  ╮ 35
   │  device design   │◄───────┤   spectral response        │ ╱
   │  database        │        │   characterization         │
   └────────┬─────────┘        └───────────────┬────────────┘
            │                                  │
            ▼                                  ▼
   ┌────────────────────────────────────────────────────┐  ╭ 41
   │      thickness correction map generation            │ ╱
   └────────────────────────┬───────────────────────────┘
                            │
                            ▼
                 ┌──────────────────────┐  ╮ 42
                 │  location specific   │ ╱
                 │  thickness correction│
                 └──────────────────────┘
```

**FIG. 3**

Incoming wafer — 43

1        2

incoming wafer silicon thickness — 22

processed wafer silicon thickness $t_{Si}$, linewidth $w$, etch — 33

anticipated mapping linewidth $w$ and — 44

optical response (IL, $BW$, $\lambda_{max}$, ...) — 49

model ideal $t_{Si\_opti}$ map for uniform optical — 45

46 — $t_{Si\_opti} > t_{Si\_min}$

N — increase thickness (EPI) $t_{Si} + \Delta t$ — 47

Y

GCIB trimming — 48

**FIG. 4**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6537606 A
- WO 2007143501 A
- US 6537606 B